Europäisches Patentamt

European Patent Office

Office européen des brevets

(11) Veröffentlichungsnummer: **0 255 882**
**A2**

(12) **EUROPÄISCHE PATENTANMELDUNG**

(21) Anmeldenummer: 87110233.1

(22) Anmeldetag: 15.07.87

(51) Int. Cl.4: **H01L 29/72** , **H01L 21/265**

(30) Priorität: 07.08.86 DE 3626744

(43) Veröffentlichungstag der Anmeldung:
17.02.88 Patentblatt 88/07

(84) Benannte Vertragsstaaten:
DE FR GB NL

(71) Anmelder: **Siemens Aktiengesellschaft Berlin und München**
**Wittelsbacherplatz 2**
**D-8000 München 2(DE)**

(72) Erfinder: **Wieder, Armin, Dr.**
**Zentnerstrasse 20**
**D-8000 München 40(DE)**
Erfinder: **Böhm, Hans-Joachim, Dr.**
**Sonntagstrasse 2**
**D-7500 Karlsruhe 1(DE)**

(54) npn-Bipolartransistor mit extrem flachen Emitter/Basis-Strukturen und Verfahren zu seiner Herstellung.

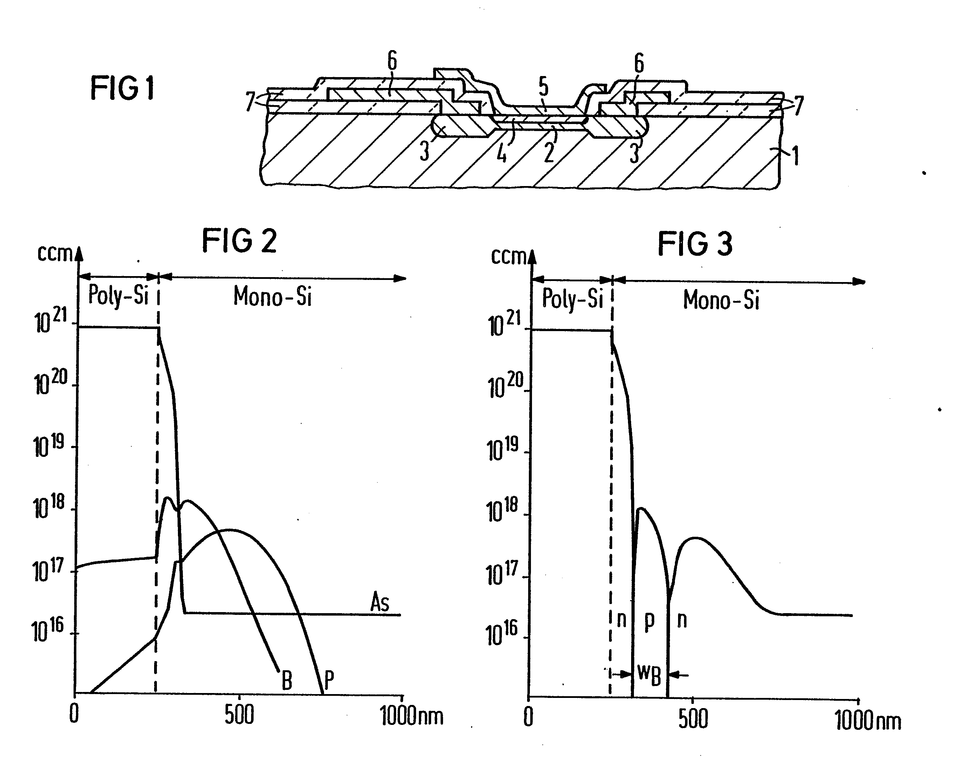

(57) Bipolartransistorstrukturen vom Typ npn mit extrem flachen Emitter/Basis-Zonen (2, 4) werden erhalten, wenn die Bildung der aktiven Basiszone (2) unter der Emitterzone (4) neben der Bor-Ionenimplantation mit einer Phosphor-Ionenimplantation mit etwas größerer Eindringtiefe erfolgt (Figur 1). Hierdurch wird der "Channeling"-Schwanz des Bordotierungsprofils umdotiert und die Basisweite $W_B$ drastisch reduziert. Die Erfindung wird bei der Herstellung hochintegrierter CMOS-Schaltungen verwendet.

FIG 3

EP 0 255 882 A2

## npn-Bipolartransistor mit extrem flachen Emitter/Basis-Strukturen und Verfahren zu seiner Herstellung.

Die Erfindung betrifft einen npn-Bipolartransistor mit extrem flachen Emitter/Basis-Strukturen sowie ein Verfahren zu seiner Herstellung.

Für Höchstfrequenzschaltungen werden Bipolartransistorstrukturen mit selbstjustierten Emitter- und Basisbereichen verwendet. Bei diesen Strukturen werden die Emitter-und Basisbereiche durch Ausdiffusion aus dotierten Polysiliziumschichten erzeugt, wobei zuerst der aktive Basisbereich durch Implantation ins Siliziumsubstrat und dann der Emitterbereich in diesem Basisbereich erzeugt wird. Diese Technik wird auch als PolyysilTechnik bezeichnet und ist aus einem Aufsatz von H. Murrmann "Modern Bipolar Technology for High Performance IC's" aus den Siemens Forschungs-und Entwicklungsberichten Band 5 (1976) Nr. 6, Seiten 353 bis 359, bekannt.

Aus diesem Aufsatz ist auch ein Verfahren zum Herstellen von selbstjustierten Bipolartransistorstrukturen bekannt, bei dem in einem p-dotierten Siliiziumsubstrat n-dotierte Gebiete erzeugt werden und in die n-dotierten Gebiete isolierte npn-Bipolartransistoren gelegt werden, wobei die n-Gebiete den Kollektor des Bipolartransistors bilden und bei dem die n-Gebiete $n^+$-dotierte Zonen bedecken, die durch tiefreichende Kollektoranschlüsse angeschlossen werden. Eine solche Struktur läßt sich vorteilhaft in einen CMOS-Prozeß integrieren, wobei die n-Wannen der Schaltung dafür verwendet werden.

Die aktive Basiszone des Bipolartransistors wird bei den bekannten Verfahren meist durch Implantation von Bor in das schwach n-dotierte Epitaxiegebiet hergestellt. Bei der Erzeugung extrem kleiner Basisweiten tritt als Problem das sogenannte "Channeling" auf, welches eine gute Prozeßkontrolle stark erschwert.

Eine mögliche Alternative zur Erzeugung einer flachen Basiszone wäre die Ausdiffusion von Bor aus einer polykristallinen Siliziumschicht. Aber auch hier läßt sich die Basisladung und -weite nur schwer kontrollieren, weil die Basis nur aus dem Schwanz des ausdiffundierten Dotierstoffprofils gebildet wird.

Aufgabe der Erfindung ist es daher, eine Bipolartransistoranordnung vom npn-Typ zu schaffen, die mit guter Prozeßkontrolle extrem flache Emitter/Basis-Strukturen aufweist.

Diese Aufgabe wird durch eine Bipolaranordnung gelöst, die durch eine, durch Implantation von Phosphor-und Borionen mit unterschiedlicher Eindringtiefe gebildete aktive Basiszone gekennzeichnet ist. Durch die Doppel-Ionenimplantation wird der "Channeling-Schwanz" des Bordotierungsprofils durch die Phosphor-Ionen umdotiert; die Basisweite wird dadurch drastisch reduziert.

Weitere Ausgestaltungen der Erfindung, insbesondere ein Verfahren zu ihrer Realisierung, ergeben sich aus den Unteransprüchen.

Der Prozeßablauf kann so erfolgen, wie er aus der deutschen Offenlegungsschrift 32 43 059 AI bekannt ist oder wie er in der deutschen Patentanmeldung P 35 44 573.4 vorgeschlagen wird. In jedem Fall werden die "buried layer" für den vergrabenen Kollektoranschluß, die Epitaxieschicht, die Kollektortiefdiffusion, die Emitterzone und die Basisanschlußzone, sowie die verschiedenen Isolationsschichten in bekannter Weise erzeugt. Die Herstellung der aktiven Basiszone unter der Emitterzone geschieht nicht durch die bisher übliche einfache Bor-Ionenimplantation, sondern durch eine Doppel-Ionenimplantation, wobei neben der eigentlichen Bor-Ionenimplantation zur Erzeugung der p-dotierten Basiszone eine Phosphor-Ionenimplantation mit etwas größerer Eindringtiefe durchgeführt wird. Gemäß einem Ausführungsbeispiel nach der Lehre der Erfindung wird die Bor-Ionenimplantation mit einer Dosis und Energie von 2 bis 4 $\times$ $10^{13}$ $cm^{-2}$ und 5 bis 25 keV und die Phosphor-Ionenimplantation mit einer Dosis und Energie von 1 $\times$ $10^{13}$ $cm^{-2}$ und 160 bis 180 keV durchgeführt. Der anschließende Temperprozeß erfolgt bei 900°C. Es empfiehlt sich vor den Implantationen eine SiO2-Schicht von 20 bis 50 nm Dicke bei 900°C aufzubringen. Die Fertigstellung der Anordnung mit Polysilizium-Emitter, Kontaktlöchern und Metallisierung erfolgt in bekannter Weise.

Im folgenden wird anhand der Figuren 1 bis 3 die Erfindung noch näher erläutert. Dabei zeigt

die Figur 1 zur Definition der aktiven Basiszone eine aus dem Stand der Technik bekannte Bipolartransistorstruktur (allerdings der Einfachheit halber ohne vergrabenen Kollektor und Epitaxieschicht) und

die Figuren 2 und 3 Dotierstoffprofile.

In Figur 1 gelten folgende Bezugszeichen:

1 = n-dotiertes Substrat
2 = aktive Basiszone
3 = inaktive Basiszone
4 = Emitterzone
5 = Polysilizium-Emitter-Anschluß
6 = Polysilizium-Basis-Anschlüsse
7 = Isolationsschicht.

Aus den Figuren 2 und 3 ist die zu erwartende Dotierstoffverteilung (Figur 2) bzw. Nettodotierstoffverteilung (Figur 3) in der Transistorstruktur zu ersehen. Dabei ist als Abszisse die Eindringtiefe in nm und als Ordinate die Dotierstoffkonzentration in ccm aufgetragen. In Figur 2 zeigt der Kurvenverlauf B das Bordotierungsprofil an und der Kurvenverlauf P das Phosphordotierungsprofil; der Kurvenverlauf As betrifft das Arsendotierungsprofil. In Figur 3 bezeichnet $W_B$ die Basisweite. Die Bereiche für die einkristalline und polykristalline Siliziumschicht sind am oberen Rand der Diagramme eingezeichnet.

Sowohl die neue Prozeßfolge, als auch die daraus resultierende neuartige Struktur bieten gegenüber den bekannten Bipolartransistorstrukturen wesentliche Vorteile:

1. Es lassen sich extrem kleine Basisweiten mit $w_B$ = 50 bis 100 nm erzielen.

2. Da das Channeling keine wesentliche Rolle mehr spielt, läßt sich die Basiszone beim Herstellungsprozeß sehr gut kontrollieren.

3. Die Dotierung der epitaktischen Schicht läßt sich noch weiter erniedrigen, ohne daß dabei die Basisweite erhöht wird.

4. Die Prozeßfolge führt zu einer optimalen Bipolartransistorstruktur mit unkompensiertem Emitter und kleiner Basis-Kollektor-Kapazität $C_{BC}$.

5. Eine Integration in CMOS-Prozesse ist ohne weiteres möglich.

**Ansprüche**

1. npn-Bipolartransistor mit extrem flachen Emitter/Basis-Strukturen, **gekennzeichnet durch**eine, durch Implantation von Phosphor-und Borionen mit unterschiedlicher Eindringtiefe gebildeten aktiven Basiszone (2).

2. Verfahren zum Herstellen von npn-Bipolartransistorstrukturen mit selbstjustierten Emitter-Basisbereichen und n-dotierten Gebieten im Substrat, die den Kollektor des Transistors bilden und vergrabene $n^+$-dotierte Zonen im Substrat bedecken, die durch tiefreichende Kollektoranschlüsse angeschlossen werden, bei dem nach dem Erzeugen des vergrabenen Kollektorbereiches im p-dotierten Substrat durch Implantation von n-dotierenden Ionen, Aufbringen einer n-dotierten Epitaxieschicht und Herstellen der Kollektoranschlußbereiche zunächst der aktive Basisbereich definiert und durch Einbringen von p-dotierenden Stoffen erzeugt wird, dann der Emitterbereich im Basisbereich und der Basisanschlußbereich durch Ausdiffusion aus polykristallinen Siliziumstrukturen, die als Anschlüsse dienen, hergestellt wird, **dadurch gekennzeichnet,** daß die aktive Basiszone (2) durch eine Doppel-Ionenimplantation gebildet wird, wobei vor den Borionen Phosphorionen mit einer etwas größeren Eindringtiefe als die Borionen in das n-dotierte Substrat (1) bzw. in das n-dotierte Gebiet (1) des Substrats implantiert werden.

3. Verfahren nach Anspruch 2, **dadurch gekennzeichnet,** daß die Phosphorionenimplantation mit einer Dosis und Energie von $1 \times 10^{13}$ $cm^{-2}$ und 160 bis 180 keV und die Borionenimplantation mit einer Dosis und Energie von 2 bis $4 \times 10^{13}$ $cm^{-2}$ und 5 bis 25 keV durchgeführt wird.

4. Verfahren nach Anspruch 2 oder 3, **dadurch gekennzeichnet,** daß vor der Doppel-Ionenimplantation auf der Oberfläche des Substrats eine 20 bis 50 nm dicke $SiO_2$-Schicht erzeugt wird.

5. Verfahren nach mindestens einem der Ansprüche 2 bis 4, **dadurch gekennzeichnet,** daß nach der Doppel-Ionenimplantation ein Temperprozeß im Bereich von 900°C durchgeführt wird.

6. Anwendung des Verfahrens nach mindestens einem der Ansprüche 2 bis 5 zum Einbau von isolierten npn-Bipolartransistorstrukturen in n- und/oder p-Kanal-MOS-Transistoren enthaltende hochintegrierte Schaltungen.

FIG 1

FIG 2

FIG 3

0 255 882